# EUROPEAN PATENT SPECIFICATION

(11) **EP 2 300 636 B1**
(45) Date of publication and mention of the grant of the patent: **23.07.2014**
(21) Application number: 09762755.8
(22) Date of filing: 09.06.2009
(51) Int. Cl.: C04B 41/52, C04B 111/00, C23C 30/00, C04B 41/87, C04B 41/89, C23C 14/06

(54) **COATED CUTTING TOOL FOR METAL CUTTING APPLICATIONS GENERATING HIGH TEMPERATURES**
BESCHICHTETES SCHNEIDWERKZEUG FÜR METALLSCHNEIDEANWENDUNGEN MIT HOHER TEMPERATURERZEUGUNG
OUTIL DE COUPE REVÊTU POUR APPLICATIONS DE COUPE DE MÉTAL PRODUISANT DES TEMPÉRATURES ÉLEVÉES

(30) Priority: 13.06.2008 SE 0801379
(43) Date of publication of application: 30.03.2011
(73) Proprietor: Seco Tools AB, 737 82 Sandviken (SE)
(72) Inventor: JOHANSSON, Mats, S- 589 37 Linköping (SE); MYRTVEIT, Toril, S- 196 30 Kungsängen (SE); COLLIN, Marianne, S- 125 54 Älvsjö (SE); SJÖLÉN, Jacob, S--737 40 Fagersta (SE); ROGSTRÖM, Lina, SE-584 31 Linköping (SE); JOHNSON, Lars, SE-582 47 Linköping (SE); ODÉN, Magnus, SE-146 40 Tullinge (SE); HULTMAN, Lars, SE-589 31 Linköping (SE); HAKANSSON, Greger, SE-583 32 Linköping (SE)
(74) Representative: Hägglöf, Henrik
(86) International application number: PCT/SE2009/050696
(87) International publication number: WO 2009/151386

(56) References cited:
- EP-A1- 0 448 720
- EP-A2- 1 378 304
- EP-A2- 1 785 504
- EP-A2- 1 785 504
- LAMNI R ET AL: "Electrical and optical properties of Zr1-xAlxN thin films", THIN SOLID FILMS, ELSEVIER-SEQUOIA S.A. LAUSANNE, CH, vol. 478, no. 1-2, 1 May 2005 (2005-05-01) , pages 170-175, XP004774116, ISSN: 0040-6090, DOI: DOI:10.1016/J.TSF.2004.10.049
- HASEGAWA ET AL: "Effects of Al contents on microstructures of Cr1-XAlXN and Zr1-XAlXN films synthesized by cathodic arc method", SURFACE AND COATINGS TECHNOLOGY, ELSEVIER, AMSTERDAM, NL, vol. 200, no. 7, 21 December 2005 (2005-12-21), pages 2409-2413, XP005181210, ISSN: 0257-8972, DOI: DOI:10.1016/J.SURFCOAT.2004.08.208
- LAMNI R ET AL: "Microstructure and nanohardness properties of Zr-Al-N and Zr-Cr-N thin films", JOURNAL OF VACUUM SCIENCE AND TECHNOLOGY: PART A, AVS /AIP, MELVILLE, NY., US, vol. 23, no. 4, 7 June 2005 (2005-06-07), pages 593-598, XP012074056, ISSN: 0734-2101, DOI: DOI:10.1116/1.1924579
- RAFAJA D. ET AL.: 'Formation of defect structures in hard nanocomposites' SURFACE & COATINGS TECHNOLOGY vol. 203, 2008, pages 572 - 578, XP025656876
- HASEGAWA, HIROYUKI ET AL.: 'Effects of Al contents on microstructures of Cr1-xAlxN and Zr1-xAlxN films synthesized by cathodic arc method' SURFACE & COATINGS TECHNOLOGY vol. 200, 2005, pages 2409 - 2413, XP005181210
- HASEGAWA, HIROYUKI ET AL.: 'Effects of second metal contents on microstructure and micro-hardness of ternary nitride films synthesized by cathodic arc method' SURFACE & COATINGS TECHNOLOGY vol. 188-189, 2004, pages 234 - 240, XP004622214
- LAMNI R. ET AL.: 'Microstructure and nanohardness properties of Zr-Al-N and Zr-Cr-N thin films' J.VAC.SCI.TECHNOL.A vol. 23, no. 4, July 2005, pages 593 - 598, XP012074056
- DEJUN, LI: 'Synthesis of ZrAIN coatings with thermal stability at high temperature' SCIENCE IN CHINA SERIES E: TECHNOLOGICAL SCIENCES vol. 49, no. 5, 2006, pages 576 - 581, XP019438534

## Description

### BACKGROUND OF THE INVENTION

The present invention relates to a cutting tool insert for machining by chip removal and wear resistant coating comprising at least one (Zr,AI)N layer with a low Zr content grown by physical vapour deposition (PVD) and preferably by cathodic arc evaporation or magnetron sputtering. This insert is particularly useful in metal cutting applications generating high temperatures, e.g., machining of steel, stainless steel and hardened steel.

TiN-layers have been widely used for surface protective applications. In order to improve the oxidation resistance of these layers, work began in the mid-1980's with adding aluminum to TiN. The compound thus formed, cubic-phase (TiₓAl₁₋ₓ)N, was found to have superior oxidation resistance and enabled greater cutting speeds during machining, prolonged tool life, machining of harder materials, and improved manufacturing economy. Improved coating performance in metal cutting applications has been obtained by precipitation hardening of (TiₓAl₁₋ₓ)N and also disclosed in US 7,083,868 and US 7,056,602.

Zr₁₋ₓAlₓN (0 ≤ x ≤ 1.0) layers have been synthesized by the cathodic arc evaporation using alloyed and/or metal cathodes, H. Hasegawa et al, Surf. Coat. Tech. 200 (2005). The peaks of Zr₁₋ₓAlₓN (x = 0.37) showed a NaCl structure that changed to a wurtzite structure at x = 0.50.

EP 1 785 504 discloses a surface-coated base material and a high hardness coating formed on or over said base material. Said high hardness coating comprises a coating layer containing a nitride compound with Al as main component and at least one element selected from the group consisting of Zr, Hf, Pd, Ir and the rare earth elements.

US 2002/0166606 discloses a method of coating a metal substrate by a metal compound coating comprising TiN, TiCN, AlTiN, TiAIN, ZrN, ZrCN, AlZrCN, or AlZrTiN using a vacuum chamber process such as physical vapor deposition (PVD) or chemical vapor deposition (CVD).

The trends towards dry-work processes for environmental protection, i.e., metal cutting operation without using cutting fluids (lubricants) and accelerated machining speed with improved process put even higher demands on the characteristics of the tool materials due to an increased tool cutting-edge temperature. In particular, coating stability at high temperatures, e.g., oxidation- and wear-resistance, has become even more crucial.

It is an object of the present invention to provide a coated cutting tool insert with improved performance in metal cutting applications at elevated temperatures.

Surprisingly, a low Zr content in (Zr,Al)N layers deposited on cutting tools inserts significantly improves their high temperature performance and edge integrity during metal cutting.

### BRIEF DESCRIPTION OF THE DRAWINGS

Fig 1; A scanning electron microscope (SEM) micrograph of a fractured (Zr_{0.17}Al_{0.83})N layer.
Fig 2; X-ray diffraction patterns vs. heat treatment temperature.
Fig 3; Hardness vs. heat treatment temperature and composition, x, in (ZrₓAl₁₋ₓ)N where □: x = 0.17, ○: x = 0.30, Δ: x = 0.50 and ◊: x = 1.00.
Fig 4; A transmission electron microscope (TEM) dark field micrograph over the (111) and (200) diffraction spots of a (Zr_{0.17}Al_{0.83})N layer showing in (A) a low magnification overview of the layer and in (B) a higher magnification.

### DETAILED DESCRIPTION OF THE INVENTION

According to the present invention, there is provided a cutting tool insert for machining by chip removal comprising a body of a hard alloy of cemented carbide, cermet, ceramics, high speed steel (HSS), polycrystalline diamond (PCD) or polycrystalline cubic boron nitride (PCBN), preferably cemented carbide and cermet, onto which a wear resistant coating is deposited comprising at least one (ZrₓAl₁₋ₓ)N layer with 0.10 < x < 0.25 preferably 0.15 < x < 0.20, as determined by, e.g., EDS or WDS techniques, consisting of a single cubic phase or a single hexagonal phase or a mixture thereof, preferably a mixture of cubic and hexagonal phases as determined by X-ray diffraction. The elemental composition is, within the measurement accuracy, preferably with a variation less than 10% throughout the layer. Variation of the composition may also occur due to normal process variations during deposition such as, e.g., rotation of the insert holder during deposition.

Said layer is 0.5 to 10 µm, preferably 0.5 to 5 µm thick, and has a nanocrystalline columnar microstructure with an average columnar width of <500 nm, preferably <100 nm, as determined by cross sectional transmission electron microscopy of a middle region of the layer, i.e., a region within 30 to 70 % of the thickness in the growth direction, and said average columnar width is the average from measuring the width of at least ten adjacent columns.

Said columns preferably comprise nanocrystalline regions with an average crystallite size < 100 nm, preferably < 50 nm, as determined by cross sectional transmission electron microscopy of the middle region of said layer i.e., a region within 30 to 70 % of the layer thickness in the growth direction. Said crystallite size is determined as the average from measuring the size of at least ten adjacent crystallites.

Said as-deposited (Zr,Al)N layer with its nanocrystalline structure has a hardness >25 GPa.

The body may further be coated with an inner single- and/or multilayer coating of, preferably TiN, TiC, Ti(C,N) or (Ti,Al)N, most preferably TiN or (Ti,Al)N, and/or an outer single- and/or multilayer coating of, preferably TiN, TiC, Ti(C,N), (Ti,Al)N or oxides, most preferably TiN or (Ti,Al)N, to a total coating thickness, including the (Zr,Al)N layer, of 0.7 to 20 µm, preferably 1 to 10 µm, and most preferably 2 to 7 µm.

The deposition methods for the layers of the present invention are based on PVD, e.g., cathodic arc evaporation or magnetron sputtering using one or more pure and/or alloyed metal (Zr,Al) cathodes or targets, respectively, resulting in the desired layer composition.

In the case of cathodic arc evaporation, (Zr,Al)N layers are grown with an evaporation current between 50 and 200 A depending on the cathode size. The layers are grown in a mixed Ar + N₂ atmosphere, preferably in a pure N₂, at a total pressure between 1.0 and 7.0 Pa, preferably between 1.5 and 4.0 Pa. The bias is between 0 and -300 V, preferably between -10 and -150 V, with a deposition temperature between 200 and 800 °C, preferably between 300 and 600 °C.

In the case of magnetron sputtering, (Zr,Al)N layers are grown with a power density applied to the sputter target between 0.5 and 15 W/cm², preferably between 1 and 5 W/cm². The layers are grown in a mixed Ar + N₂ or pure N₂ atmosphere at a total pressure between 0.13 and 7.0 Pa, preferably between 0.13 and 2.5 Pa. The bias is between 0 and -300 V, preferably between -10 and -150 V, with a deposition temperature between 200 and 800 °C, preferably between 300 and 600 °C.

The invention also relates to the use of cutting tool inserts according to the above for machining of steel, stainless steel and hardened steel at cutting speeds of 50 - 500 m/min, preferably 75 - 400 m/min, with an average feed, per tooth in the case of milling, of 0.08 - 0.5 mm, preferably 0.1 - 0.4 mm, depending on cutting speed and insert geometry.

### Example 1

Cemented carbide inserts with composition 94 wt% WC - 6 wt% Co (fine grained) were used.

Before deposition, the inserts were cleaned according to standard practice. The deposition system was evacuated to a pressure of less than 0.08 Pa, after which the inserts were sputter cleaned with Ar ions. Single (ZrₓAb₁₋ₓ)N layers were grown using cathodic arc evaporation using (Zr,Al) cathodes, resulting in a layer compositions between 0.02 ≤ x ≤ 0.99. The layers were grown at 400 °C, in pure N₂ atmosphere at a total pressure of 2.5 Pa, using a bias of -100 V and an evaporation current between 100 A and 150 A (higher current for Zr concentration >50 at%) to a total thickness of 3 µm.

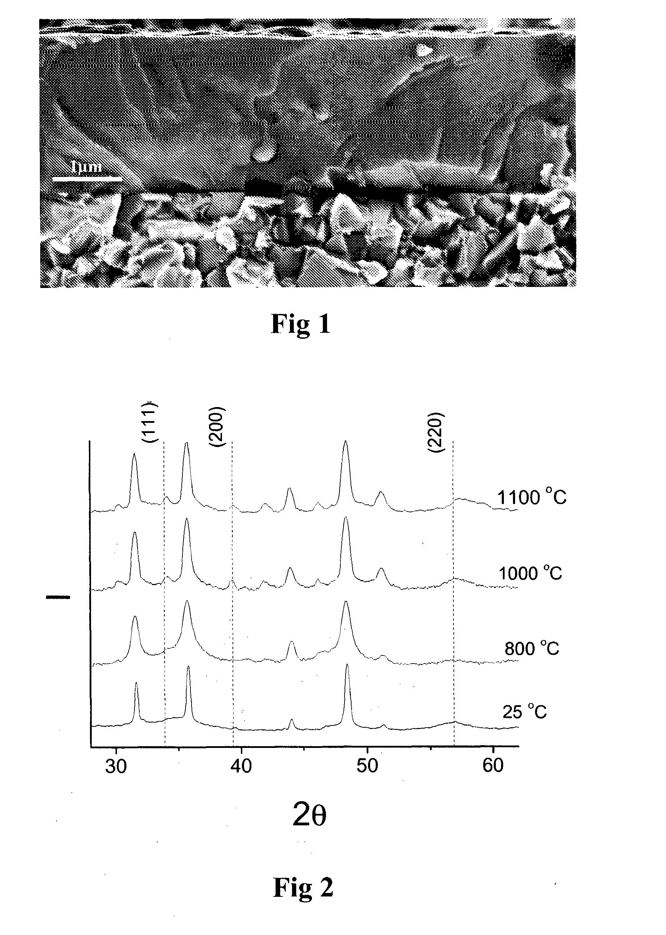

Fig 1 shows a SEM micrograph of a typical layer in a (fractured) cross-section according to the invention with a glassy appearance common for nanocrystalline structures.

The metal composition, x, of the (ZrₓAl₁₋ₓ)N layers was obtained by energy dispersive spectroscopy (EDS) analysis area using a LEO Ultra 55 scanning electron microscope with a Thermo Noran EDS. Industrial standards and ZAF correction were used for the quantitative analysis and evaluated using a Noran System Six (NSS version 2) software (see table 1).

**Table 1**

| **Layer** | **x in (ZrₓAl₁₋ₓ)N** |
|---|---|
| zr-211 | 0.02 |
| zr-221 | 0.10 |
| zr-111 | 0.17 |
| zr-121 | 0.17 |
| zr-131 | 0.19 |
| zr-011 | 0.26 |
| zr-021 | 0.30 |
| zr-031 | 0.33 |
| zr-041 | 0.48 |
| zr-051 | 0.50 |
| zr-012 | 0.65 |
| zr-062 | 0.76 |
| zr-092 | 0.99 |

In order to simulate age hardening, i.e., an increased hardening effect of the coating with time, accelerated test conditions were used by conducting controlled isothermal heat treatments of the inserts in inert Ar atmosphere up to 1200 °C for 120 min. Also, this is the typical temperature close to the cutting edge of the insert during metal machining.

The XRD patterns of the as-deposited layers and heat treated layers were obtained using Cu K alpha radiation and a θ-2θ configuration. The layer peaks, typically, are rather broad characteristic of a nanocrystalline structure. Also, the layer crystalline structure remains essentially unaffected with heat treatment temperatures up to 1100 °C. As an example, Fig 2 shows XRD patterns of (Zr_{0.17}Al_{0.83})N layer as a function of heat treatment temperature with the cubic phase of (Zr,Al)N marked with dotted lines, the unindexed peaks originate from tungsten carbide and possibly also with a small contribution from a hexagonal (Zr,Al)N phase.

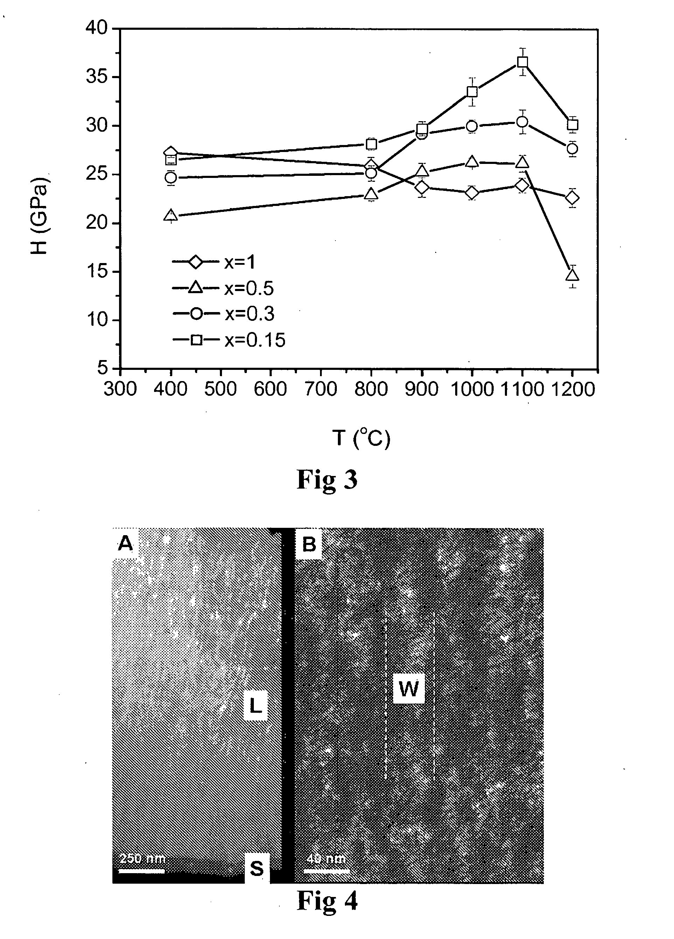

Hardness data was estimated by the nanoindentation technique of the layers using a UMIS nanoindentation system with a Berkovich diamond tip and a maximum tip load of 25 mN. Indentations were made on polished surfaces. Fig 3 shows the hardness (H) of (ZrₓAl₁₋ₓ)N layers as a function of heat treatment and composition, x. For x ≤ 0.30, an unexpected increase of the age hardening is obtained. Specifically, the increase in hardness for x = 0.17 is more than 35 %, i.e., with values from 27 to 37 GPa.

Cross-sectional dark field transmission electron microscopy (TEM) was used to study the microstructure of the layers with a FEI Technai G² TF 20 UT operated at 200 kV. The sample preparation comprised standard mechanical grinding/polishing and ion-beam sputtering. Figs 4A and 4B show cross sectional dark field TEM micrograph over (111) and (200) reflections of a (Zr_{0.17}Al_{0.83})N layer according to the invention. Fig 4A shows that the layer (L) exhibits a columnar microstructure with an average columnar width (Fig 4B), W, of 40 nm, comprising crystalline regions (light contrast) with size < 50 nm.

### Example 2

Inserts from example 1 were tested according to:

| | |
|---|---|
| Geometry: | CNMA120408-KR |
| Application: | Longitudinal turning |
| Work piece material: | SS1672 |
| Cutting speed: | 240 m/min |
| Feed: | 0,2 mm/rev |
| Depth of cut: | 2 mm |

Flank wear was measured after 5 min of turning with the following results.

**Table 2**

| **Layer** | **x in (ZrₓAl₁₋ₓ)N** | **Flank wear (mm)** |
|---|---|---|
| zr-211 | 0.02 | - |
| zr-221 | 0.1 | 0.12 |
| zr-111 | 0.17 | < 0.1 |
| zr-121 | 0.17 | < 0,1 |
| zr-131 | 0.19 | - |
| zr-011 | 0.26 | - |
| zr-021 | 0.3 | 0.15 |
| zr-031 | 0.33 | - |
| zr-041 | 0.48 | - |
| zr-051 | 0.5 | 0.2 |
| zr-012 | 0.65 | - |
| zr-062 | 0.76 | 0.25 |
| zr-092 | 0.99 | 0.23 |

A flank wear <0.2 with the selected cutting data is satisfactory.

## Claims

1. Cutting tool insert comprising a body of cemented carbide, cermet, ceramics, high speed steel (HSS), polycrystalline diamond (PCD) or polycrystalline cubic boron nitride (PCBN), a hard and wear resistant coating is applied, said coating comprising at least one layer **characterised in that** said layer consists of (ZrₓAl₁₋ₓ)N with 0.10 < x < 0.25, preferably 0.15 < x < 0.20, and that the layer has a thickness between 0.5 and 10 µm, preferably between 0.5 and 5 µm, and a nanocrystalline columnar microstructure consisting of a mixture of hexagonal and cubic phases.

2. Cutting tool insert according to claim 1, wherein the average columnar width is <500 nm, preferably <100 nm.

3. Cutting tool insert according to any of the preceding claims, wherein the columns comprise crystalline regions with size <100 nm, preferably <50 nm.

4. Cutting tool insert according to any of the preceding claims, wherein said layer has a hardness >25 GPa.

5. Cutting tool insert according to any of the preceding claims, wherein said body having an inner single- and/or multilayer coating of, e.g., TiN, TiC, Ti(C,N) or (Ti,Al)N, preferably TiN or (Ti,Al)N and/or an outer single- and/or multilayer coating of, e.g., TiN, TiC, Ti(C,N), (Ti,Al)N or oxides, preferably TiN or (Ti,Al)N, to a total coating thickness of 0.7 to 20 µm, preferably 1 to 10 µm, and most preferably 2 to 7 µm.

6. Use of a cutting tool insert according to any of claims 1 - 5 for metal cutting applications in steel, stainless steel and hardened steel at cutting speeds of 50 - 500 m/min, preferably 75 - 400 m/min, with an average feed, per tooth in the case of milling, of 0.08 - 0.5 mm, preferably 0.1 - 0.4 mm depending on cutting speed and insert geometry.

## Patentansprüche

1. Einsatz für ein Schneidwerkzeug, welcher einen Körper aus Hartmetall, Cermet, Keramik, Hochgeschwindigkeitsstahl (HSS), polykristallinem Diamant (PCD) oder polykristallinem kubischem Bornitrit (PCBN) aufweist, wobei eine harte und verschleißfeste Beschichtung aufgebracht ist, wobei die Beschichtung zumindest eine Schicht aufweist, **dadurch gekennzeichnet, dass** die Schicht aus (ZrₓAl₁₋ₓ)N besteht mit 0,10<x<0,25, vorzugsweise 0,15<x<0,20, und dass die Schicht eine Dicke zwischen 0,5 und 10 µm, vorzugsweise zwischen 0,5 und 5 µm, und eine nanokristalline säulenartige Mikrostruktur bestehend aus einer Mischung aus hexagonalen und kubischen Phasen aufweist.

2. Einsatz für ein Schneidwerkzeug nach Anspruch 1, wobei die durchschnittliche Säulenbreite <500 nm, vorzugsweise <100 nm ist.

3. Einsatz für ein Schneidwerkzeug nach einem der vorangehenden Ansprüche, wobei die Säulen kristalline Bereiche mit einer Größe <100 nm, vorzugsweise <50 nm aufweisen.

4. Einsatz für ein Schneidwerkzeug nach einem der vorangehenden Ansprüche, wobei die Schicht eine Härte >25 GPa aufweist.

5. Einsatz für ein Schneidwerkzeug nach einem der vorangehenden Ansprüche, wobei der Körper eine innere ein- und/oder mehrschichtige Beschichtung beispielsweise aus TiN, TiC, Ti(C,N) oder (Ti,Al)N, vorzugsweise TiN oder (Ti,Al)N, und/oder eine äußere ein- und/oder mehrschichtige Beschichtung beispielsweise aus TiN, TiC, Ti(C,N), (Ti,Al)N oder Oxiden, vorzugsweise aus TiN oder (Ti,Al)N, aufweist mit einer Gesamtdicke der Beschichtung von 0,7 bis 20 µm, vorzugsweise 1 bis 10 µm und am besten 2 bis 7 µm.

6. Verwendung eines Einsatzes für ein Schneidwerkzeug nach einem der Ansprüche 1 bis 5 für Metallschneidanwendungen in Stahl, Edelstahl und gehärtetem Stahl bei einer Schneidgeschwindigkeit von 50-500 m/min, vorzugsweise 75-400 m/min, mit einem durchschnittlichen Vorschub, pro Zahn im Fall von Fräsen, von 0,08-0,5 mm, vorzugsweise 0,1-0,4 mm, in Abhängigkeit von der Schneidgeschwindigkeit und der Geometrie des Einsatzes.

## Revendications

1. Plaquette d'outil de coupe comprenant un corps fait de carbure cémenté, de cermet, de céramiques, d'aciers rapides (HSS), de diamant polycristallin (PCD) ou de nitrure de bore cubique polycristallin (PCBN), un revêtement dur et résistant à l'usure est appliqué, ledit revêtement comprenant au moins une couche **caractérisée en ce que** ladite couche est constituée de (ZrₓAl₁₋ₓ)N avec 0,10 < x < 0,25, de préférence 0,15 < x < 0,20, et **en ce que** la couche présente une épaisseur entre 0,5 et 10 µm, de préférence entre 0,5 et 5 µm, et une microstructure columnaire nanocristalline constituée d'un mélange de phases hexagonales et cubiques.

2. Plaquette d'outil de coupe selon la revendication 1, dans laquelle la largeur columnaire moyenne est < 500 nm, de préférence < 100 nm.

3. Plaquette d'outil de coupe selon l'une quelconque des revendications précédentes, dans laquelle les colonnes comprennent des régions cristallines d'une taille < 100 nm, de préférence < 50 nm.

4. Plaquette d'outil de coupe selon l'une quelconque des revendications précédentes, dans laquelle ladite couche présente une dureté > 25 GPa.

5. Plaquette d'outil de coupe selon l'une quelconque des revendications précédentes, dans laquelle ledit corps ayant un revêtement intérieur à une seule couche ou à plusieurs couches de, par exemple, TiN, TiC, Ti(C,N) ou (Ti,Al)N, de préférence TiN ou (Ti,Al)N et/ou un revêtement extérieur à une seule couche ou à plusieurs couches de, par exemple, TiN, TiC, Ti(C,N), (Ti,Al)N ou des oxydes, de préférence TiN ou (Ti,Al)N, pour une épaisseur totale de revêtement de 0,7 à 20 µm, de préférence de 1 à 10 µm, et de façon davantage préférée de 2 à 7 µm.

6. Utilisation d'une plaquette d'outil de coupe selon l'une quelconque des revendications 1 à 5 pour des applications de coupe de métal dans l'acier, l'acier inoxydable et l'acier durci à des vitesses de coupe de 50 à 500 m/min, de préférence de 75 à 400 m/min, avec une avance moyenne, par dent dans le cas d'un fraisage, de 0,08 à 0,5 mm, de préférence de 0,1 à 0,4 mm en fonction de la vitesse de coupe et de la géométrie de plaquette.
